# FASCICULE DE BREVET EUROPEEN

(11) **EP 3 632 839 B1**
(45) Date de publication et mention de la délivrance du brevet: **12.11.2025**
(21) Numéro de dépôt: 19208806.0
(22) Date de dépôt: 19.12.2014
(51) Int. Cl.: B81C 99/00, G04D 3/00, G04B 15/14, G04B 17/06, G04B 19/04

(54) **COMPOSANT HORLOGER**
UHRKOMPONENTE
CLOCK COMPONENT

(30) Priorité: 20.12.2013 EP 13198950
(43) Date de publication de la demande: 08.04.2020
(62) Demande divisionnaire de: 14827755.1
(73) Titulaire: ROLEX SA, 1211 Genève 26 (CH)
(72) Inventeur: BOSSART, Richard, 1004 Lausanne (CH); MICHELET, Edward, 2502 BIENNE (CH)
(74) Mandataire: Moinas & Savoye SARL

(56) Documents cités:
- EP-A1- 0 732 635
- EP-A1- 2 145 857
- WO-A1-2013/093108
- JP-A- H11 352 249

## Description

La présente invention concerne un procédé de fabrication d'un composant horloger réalisé à partir d'un matériau micro-usinable. Elle concerne aussi un composant horloger en tant que tel.

Il est connu de fabriquer des composants horlogers à partir d'un matériau micro-usinable tel que le silicium et par des techniques issues de la microélectronique, notamment par gravure ionique réactive profonde (en anglais *Deep Reactive Ion Etching DRIE).* Le procédé de fabrication comprend généralement les étapes suivantes :
- se munir d'une plaque en matériau micro-usinable, par exemple en silicium,
- former le composant horloger, par gravure à travers la totalité de l'épaisseur de la plaque,
- libérer le composant en le séparant du reste de la plaque.

L'utilisation de matériaux et de techniques de fabrication issues de la microélectronique offre des possibilités très intéressantes, notamment en termes de précision. Une difficulté à surmonter est toutefois de libérer le composant, sans l'endommager. Généralement, des attaches, ou ponts de matière, sont prévues entre le composant horloger et le reste de la plaque. Ces attaches ont pour rôle de maintenir la pièce solidaire de la plaque pendant toute la fabrication du composant, notamment pendant des traitements appliqués au composant après la gravure (traitement thermique, dépôt d'un revêtement, etc.), tout en facilitant la libération du composant en fin de fabrication.

Le document EP2145857 décrit un procédé de fabrication d'un composant horloger analogue à celui décrit ci-dessus. Des ponts de matière sont gravés et maintiennent le composant solidaire de la plaque pendant les différentes étapes de fabrication du composant horloger. Afin de faciliter la libération du composant en fin de fabrication, les ponts de matière comportent une section rétrécie à l'extrémité reliée au composant. Cela permet de créer une zone de faiblesse facilitant la rupture des ponts de matière. En fin de fabrication, le composant horloger est libéré de la plaque par rupture fragile du matériau au niveau des attaches, ou ponts de matière, en réponse à une sollicitation mécanique adaptée.

La casse du matériau par rupture fragile entre le pont de matière et le composant est difficilement contrôlable.

Le document WO2013/093108 décrit un procédé de fabrication d'une pièce micromécanique à partir d'une plaque en un matériau micro-usinable, des attaches étant ménagées entre la pièce et la plaque. Ces attaches sont affaiblies localement par amincissement pour créer des articulations. Celles-ci sont adaptées pour permettre un détachage du composant par un effort de torsion dans le plan de la plaque. Il en résulte une rupture entre la pièce et la plaque qui manque de précision. L'endroit de la rupture n'est pas précisément déterminable a priori. Elle sera située le long de l'attache affaiblie, sans qu'il soit possible de savoir à l'avance si elle sera proche de la pièce ou de la plaque. Cela peut s'avérer gênant tant sur le plan fonctionnel que esthétique. De plus, pour libérer la pièce par torsion dans le plan de la plaque, il faut prévoir de la place autour de la pièce pour permettre un déplacement relatif de la plaque et de la pièce. Cela oblige à réduire le nombre de pièces fabriquées à partir d'une plaque.

Le document EP0732635A1 divulgue la fabrication d'ancres d'échappement dans une plaquette en silicium.

La présente invention vient améliorer la situation.

A cet effet, l'invention concerne un composant horloger et un procédé de fabrication d'un tel composant horloger selon les revendications.

L'invention sera mieux comprise à l'aide de la description suivante de différents exemples de réalisation du procédé de fabrication d'un composant horloger, d'une plaque de matériau micro-usinable intégrant un composant horloger et d'un composant horloger selon l'invention, en référence aux dessins annexés sur lesquels :
- les figures 1A, 1B et 1C représentent respectivement une vue de dessus et une vue en coupe (dans le plan yz) d'une attache entre un composant horloger et une plaque de matériau micro-usinable, et une vue partielle du composant horloger, de la plaque et de l'attache, selon une première forme de réalisation ne faisant pas partie de l'objet des revendications ;
- la figure 2 représente une vue d'un pont de matière entre un composant horloger et une plaque de matériau micro-usinable, selon l'art antérieur ;
- la figure 3 représente une vue de dessus d'un pont de matière entre un composant horloger et une plaque de matériau micro-usinable, selon une forme de réalisation analogue à celle des figures 1A et 1B ;
- la figure 4 représente une vue de dessus d'un pont de matière entre un composant horloger et une plaque de matériau micro-usinable, selon une deuxième forme de réalisation faisant partie de l'objet des revendications ;
- la figure 5 représente une vue de dessus d'un pont de matière entre un composant horloger et une plaque de matériau micro-usinable, selon une variante de la deuxième forme de réalisation ;
- la figure 6 représente une vue agrandie et partielle d'une zone de pré-détachage d'un pont de matière selon une variante de la deuxième forme de réalisation ;
- les figures 7A et 7B représentent des zones de rupture respectivement d'un composant horloger selon l'art antérieur et d'un composant horloger selon la première forme de réalisation ;
- la figure 8 représente un autre exemple illustratif d'une surface de rupture obtenue par la mise en œuvre du procédé de l'invention,
- la figure 9 représente un organigramme des étapes du procédé de fabrication, selon un mode de réalisation particulier ;
- les figures 10A à 10F représentent une vue de détail de la zone de pré-détachage d'une attache entre un composant horloger et une plaque de matériau micro-usinable, selon une première forme de réalisation (figures 10C et 10D), une deuxième forme de réalisation (10E et 10F) et selon une autre forme de réalisation (10A et 10B).

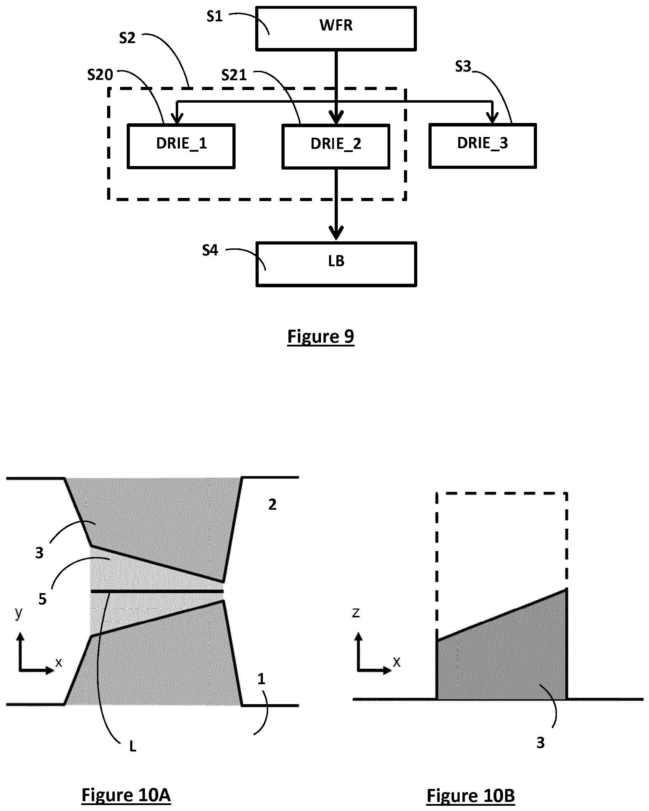

En référence à la figure 9, le procédé de l'invention comprend principalement quatre étapes S1, S2, S3 et S4 destinées à fabriquer un composant horloger 1 à partir d'un matériau micro-usinable.

Par matériau « micro-usinable », on entend désigner tout matériau adapté pour le micro-usinage. Selon le dictionnaire professionnel illustré de l'horlogerie Berner, le micro-usinage désigne *« l'ensemble des techniques issues de la microélectronique (attaques chimiques, photolithographie, déposition de couches minces en phase vapeur, etc.), additionné d'autres techniques permettant l'usinage d'une vaste gamme de matériaux tels que semiconducteurs, céramiques, métaux, certains polymères, etc. ».* Le matériau micro-usinable utilisé dans les exemples de réalisation décrits ci-après est le silicium. D'autres matériaux micro-usinables pourraient évidemment être utilisés à la place, comme par exemple le diamant, le quartz et la céramique.

L'étape S1 consiste à se munir d'une plaque 2 de matériau micro-usinable, ici une plaquette (ou « wafer ») de silicium, analogue à celles utilisées pour la fabrication de composants microélectroniques. La plaquette a par exemple une épaisseur de 150 µm. Bien évidemment, on peut utiliser d'autres épaisseurs de plaquette.

L'étape S2 consiste à former dans la plaque un composant horloger 1 et une ou plusieurs attaches 3 de maintien du composant 1 au reste de la plaque 2. Le composant horloger 1 et ses attaches 3 sont réalisés de façon simultanée, respectivement lors de sous-étapes référencées S20 (« DRIE_1 ») et S21 (« DRIE_2 »), par photolithographie suivie d'une gravure ionique réactive profonde. Lors de ces étapes S20 et S21, on grave dans la plaque 2, ici dans toute son épaisseur, des parties autour du composant 1 et des attaches 3. Autrement dit, on grave dans la plaque 2 un motif composé d'ouvertures traversantes, les formes de celles-ci étant adaptées pour former le composant 1 et ses attaches 3.

En variante, pour former le composant horloger, on pourrait utiliser une plaque formée de plusieurs couches, par exemple une plaque SOI formée de deux couches en Si prenant en sandwich une couche en SiO2, où l'une des couches en Si est utilisée pour former le composant, et l'autre couche en Si est utilisée comme support. Dans un tel cas, on entend par « ouverture traversante » une ouverture qui traverse toute la couche en Si dans laquelle est formée le composant, et non une ouverture qui traverse toute la plaque SOI.

Le rôle des attaches 3 est de maintenir le composant horloger 1 solidaire de la plaque 2 pendant la fabrication et de permettre une libération du composant horloger 1, par rupture de l'attache 3, en fin de fabrication. Les attaches 3 sont des ponts de matière entre le composant horloger gravé 1 et le reste de la plaque 2. Elles peuvent avoir des formes variées.

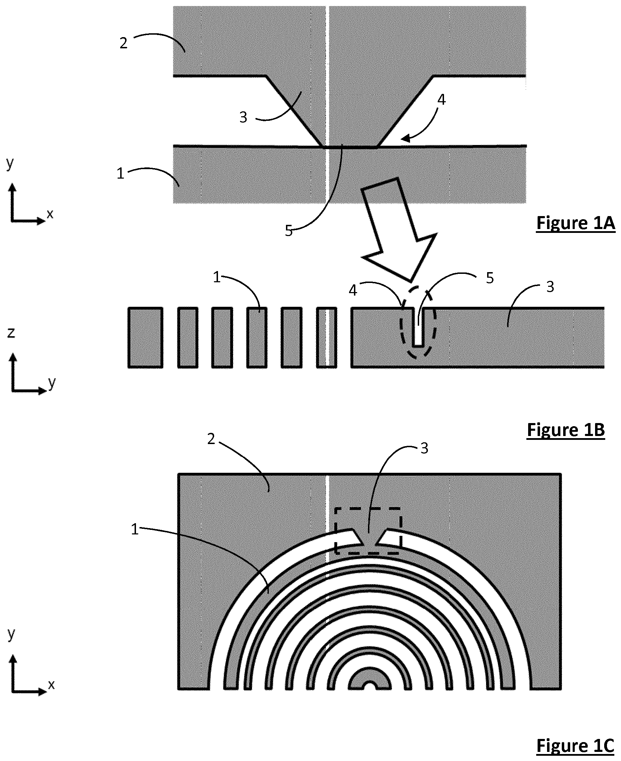

Par définition, on appelle « longueur » d'une attache, la dimension de l'attache selon une direction longitudinale reliant les milieux des deux extrémités de liaison de l'attache (respectivement au reste de la plaque 2 et au composant 1), dans le plan de la plaque 2 (c'est-à-dire un plan parallèle aux surfaces supérieure et inférieure de la plaque, à travers lequel celle-ci s'étend). De façon analogue, on appelle « largeur » la dimension de l'attache selon une direction perpendiculaire à la direction longitudinale. Sur les figures 1A et 1B, la longueur de l'attache 3 correspond à la dimension selon l'axe y et sa largeur correspond à la dimension selon l'axe x.

Dans l'exemple de réalisation illustré par les figures 1A et 1B, la largeur de l'attache 3 diminue de façon continue depuis son extrémité de liaison au reste de la plaque 2 jusqu'à son extrémité de liaison au composant horloger 1. On pourrait toutefois envisager d'autres formes d'attache 3, notamment une attache de largeur constante, avec éventuellement un rétrécissement à proximité de l'extrémité de liaison au composant.

Sur les figures 1A, 1B et 1C, le composant horloger 1 représenté est un spiral (seule une moitié du spiral, du centre au bord, étant représentée sur la figure 1B et 1C). Bien évidemment, le procédé de l'invention s'applique à la fabrication d'autres composants horlogers. Le composant horloger peut être une entité prête à être montée dans un mouvement (par exemple une aiguille, un ressort, etc.) ou une pièce destinée à être assemblée à une ou plusieurs autres pièces (par exemple un spiral à l'axe de balancier, une planche de roue à son axe, une ancre à la tige (ou axe) d'ancre, un balancier à l'axe de balancier, etc) avant montage.

L'étape S3 consiste à réaliser, pour chaque attache 3, le long d'une ligne de rupture souhaitée de l'attache 3, une zone de pré-détachage 4.

Par « ligne de rupture », on entend désigner une ligne dans le plan de la plaque le long de laquelle la rupture du matériau est souhaitée lors de la libération du composant 1 de la plaque 2. La ligne de rupture comprend ici un segment droit s'étendant dans le sens de la largeur de l'attache 3 (c'est-à-dire selon la direction x), et sur la totalité de la largeur de l'attache 3, à l'extrémité de liaison de l'attache 3 au composant 1. On pourrait évidemment envisager d'autres formes de ligne de rupture et d'autres emplacements (par exemple au milieu de l'attache, ou à l'extrémité de liaison avec la plaque).

La zone de pré-détachage 4 s'étend le long de la ligne de rupture, à l'extrémité de liaison de l'attache 3 au composant horloger 1, sur toute la largeur de l'attache 3 (selon la direction x sur la figure 1A). La longueur de la zone de pré-détachage 4, c'est-à-dire sa dimension le long de la ligne de rupture (soit selon la direction x sur la figure 1A), est par exemple comprise entre 20 et 150 µm.

Dans l'exemple de réalisation représenté sur les figures 1A et 1B, pour réaliser la zone de pré-détachage 4, on grave une ouverture 5 qui s'étend de façon continue le long de la totalité de la ligne de rupture et traverse ainsi l'attache 3 dans le sens de sa largeur. L'ouverture 5 a la forme d'une tranchée s'étendant selon la direction x et ayant une section transversale en U droit (figure 1B).

La profondeur de la tranchée 5 est par exemple égale à environ 75% de l'épaisseur totale de la plaque (ou du composant) et sa largeur (c'est-à-dire sa dimension selon la direction y) est par exemple de l'ordre de 4 µm. La profondeur et la largeur de la tranchée 5 pourraient évidemment avoir d'autres valeurs. Par exemple, la profondeur peut être supérieure ou égale à la moitié de l'épaisseur de la plaque (ou du composant) et inférieure ou égale à 90% de l'épaisseur de la plaque (ou du composant), préférentiellement inférieure ou égale à 60% de ladite épaisseur. La largeur peut être supérieure ou égale à 1 µm et inférieure ou égale à 10 µm, préférablement inférieure à 5 µm.

La gravure du composant horloger 1 (« DRIE_1 ») et la gravure de l'ouverture 5 (« DRIE_3 ») de la zone de pré-détachage 4 peuvent être réalisées de façon simultanée par gravure ionique réactive profonde (DRIE).

L'ouverture 5 permet de créer dans l'attache 3, à l'extrémité de liaison de l'attache 3 au composant 1, une zone de plus faible résistance mécanique (c'est-à-dire la zone de pré-détachage 4) et d'amorcer la rupture à l'endroit souhaité sur le composant 1.

L'étape S4 consiste à libérer le composant horloger 1 de la plaque 2, par rupture ou casse des attaches 3 le long de leur ligne de rupture. La rupture peut être provoquée en exerçant sur l'attache 3 une force mécanique dans une direction perpendiculaire, ou sensiblement perpendiculaire, au plan de la plaque (correspondant à la direction z sur les figures 1A et 1B). Par « sensiblement perpendiculaire », on entend désigner une direction présentant un angle de plus ou moins 10° par rapport à la direction perpendiculaire à la plaque (ou perpendiculaire au plan de la plaque). En variante, on provoque la rupture en exerçant sur l'attache 3 une force mécanique selon une direction présentant un angle inférieur ou égal à 45° par rapport à une direction perpendiculaire à la plaque, notamment inférieur ou égal à 30° par rapport à une direction perpendiculaire à la plaque. Le matériau de la plaque 1 étant un matériau fragile, n'ayant pas de domaine de déformation plastique, la force appliquée perpendiculairement, ou sensiblement perpendiculairement, ou bien selon une direction proche de la perpendiculaire à la plaque, a pour effet de casser le matériau au niveau de la zone de pré-détachage 4, le long de la ligne de rupture. La rupture est facilitée et contrôlée grâce à la zone de pré-détachage 4. On pourrait également envisager de libérer le composant 1 de la plaque 2 en complétant la gravure de l'attache au niveau de la zone de pré-détachage 4 par un traitement laser, notamment avec un équipement laser à impulsions femtosecondes.

La rupture par sollicitation mécanique dans une direction perpendiculaire au plan de la plaque, autrement dit par une traction ou une torsion suivant la direction z, est simple à mettre en œuvre et favorable pour réaliser des composants, notamment des spiraux ou des roues. A contrario, la rupture par sollicitation mécanique dans un plan de la plaque, autrement dit par une torsion suivant une direction contenue dans le plan x-y, par exemple en sollicitant une articulation, ne serait pas pratique à mettre en œuvre. En effet, cela nécessiterait de prévoir de la place autour du composant pour permettre le déplacement des éléments, cette place ne pouvant pas conséquent pas être utilisée pour la réalisation d'autres composants.

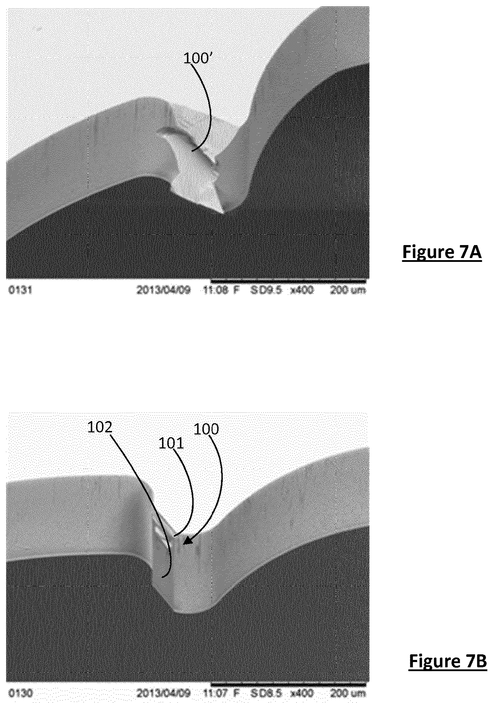

Le composant horloger libéré 1 comporte, sur sa tranche, une surface de rupture 100, telle que représentée à titre d'exemple illustratif sur la figure 7B. Cette surface 100 comporte deux parties adjacentes distinctes, l'une 102 gravée et l'autre 101 rompue. La partie 102 correspond à l'une des parois latérales en U de l'ouverture 5 gravée, alors que la partie 101 correspond au fond du U rompu. Sur la figure 7A, à des fins de comparaison, on a représenté une surface de rupture 100' obtenue avec une attache selon l'art antérieur, sans zone de pré-détachage 4. On constate que la surface de rupture 100 de la figure 7B est plus nette, plus propre et moins étendue que la surface de rupture 100'.

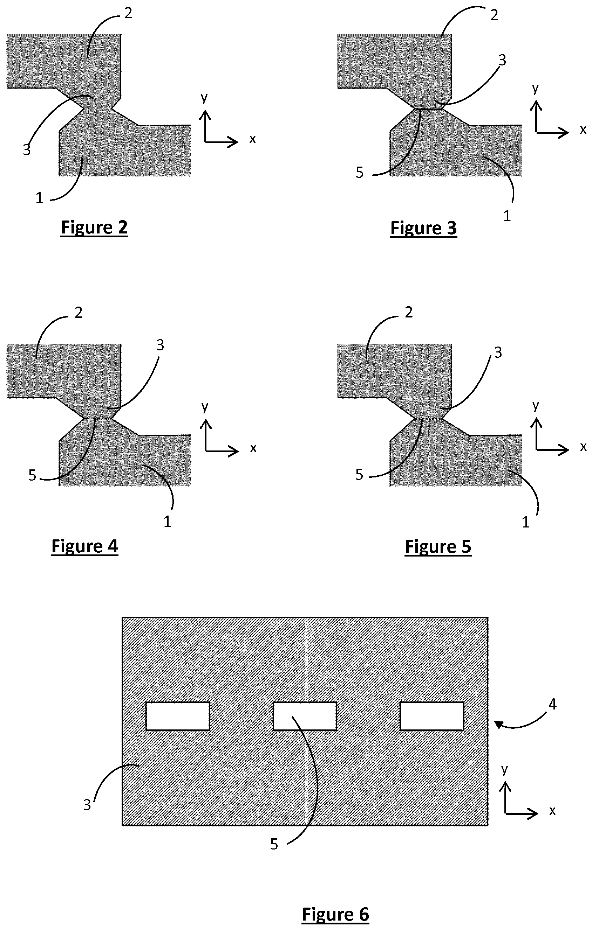

On peut envisager différentes formes de réalisation de la zone de pré-détachage 4. Sur les figures 3, 4 et 5, on a représenté schématiquement trois exemples de réalisation distincts. Par souci de clarté, les éléments analogues ou correspondants représentés sur les différentes figures portent les mêmes références.

Sur la figure 3, la zone de pré-détachage 4 comprend une ouverture 5 sous la forme d'une tranchée qui s'étend à l'extrémité de liaison de l'attache 3 au composant 1, sur toute la largeur de l'attache 3, le long d'une ligne de rupture droite. Il s'agit d'une forme de réalisation analogue à celle des figures 1A et 1B.

Sur les figures 4 et 5, la zone de pré-détachage 4 comprend une pluralité d'ouvertures gravées 5 alignées le long de la ligne de rupture (celle-ci n'étant pas représentée par souci de clarté, mais étant analogue à celle de la figure 3) et séparées par des ponts non gravés. Les ponts et les ouvertures 5 sont ici de même longueur. Ils pourraient évidemment être de longueurs différentes. Les ouvertures 5 sont de forme parallélépipédique. Elles peuvent être borgnes, c'est-à-dire gravées dans une partie de l'épaisseur de la plaque, ou traversantes, c'est-à-dire gravées dans la totalité de l'épaisseur de la plaque. Les formes de réalisation des figures 4 et 5 diffèrent par les dimensions des ouvertures 5. Sur la figure 4, les ouvertures 5 ont une largeur (selon la direction y) de 2 µm et une longueur (selon la direction x) de 10 µm. Sur la figure 5, les ouvertures 5 ont une largeur (selon la direction y) de 2 µm et une longueur (selon la direction x) de 2 µm. Bien entendu, les dimensions et formes des ouvertures 5 pourraient être différentes. Les dimensions des ouvertures 5 alignées le long de la ligne de rupture peuvent par exemple être comme suit :
- longueur (le long de la ligne de rupture) comprise entre 2 µm et 10 µm ;
- largeur comprise entre 1 µm et 5 µm ;
- profondeur supérieure ou égale à la moitié de l'épaisseur de la plaque.

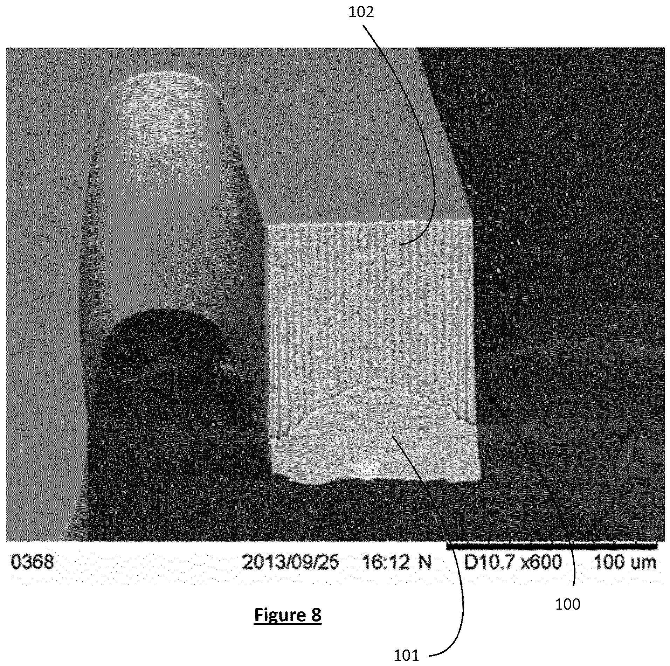

Sur la figure 8, on a représenté, à titre d'exemple illustratif, une zone de rupture 100 obtenue avec une zone de pré-détachage 4 comportant une pluralité d'ouvertures 5 alignées le long d'une ligne de rupture et ayant les caractéristiques suivantes :
- largeur de l'attache 3 à l'extrémité de liaison au composant 1 de 100µm,
- largeur des ouvertures de pré-détachage 5 de 4 µm ;
- longueur des ouvertures de pré-détachage 5 de 2 µm ;
- espace inter-ouvertures de 2 µm ;
- profondeur des ouvertures 5 égale à environ 80% de l'épaisseur totale de la plaque.

Dans ce cas, la zone de rupture 100 comprend une partie rompue 101 (c'est-à-dire une surface de rupture obtenue par rupture du matériau) et une partie 102 comportant une succession alternée de rainures gravées et de rainures rompues, disposées verticalement. Les deux parties 101 et 102 sont disposées l'une au-dessous de l'autre selon l'épaisseur du composant 1. Notons que sur la figure 8, la frontière entre la partie rompue 101 et la partie rainurée 102 est courbe du fait que la vitesse de gravure n'est pas égale sur toute la longueur de la ligne de rupture, les zones situées près des extrémités de cette ligne de rupture étant attaquées plus rapidement qu'au centre.

Dans la description qui précède, le composant horloger 1 et la ou les ouvertures 5 sont gravées en même temps. En variante, la gravure de la ou des ouvertures 5 et celle du composant horloger 1 peuvent être réalisées séparément. Dans ce cas, la ou les ouvertures peuvent être réalisées par diverses techniques d'ablation, par exemple par gravure DRIE, par ablation à l'aide d'impulsions femtosecondes émises par un équipement laser, par ablation mécanique (scie diamantée), ou autre. Préférentiellement, le composant horloger 1 et la ou les ouvertures 5 sont gravées en même temps.

Pour graver séparément le composant horloger 1 et l'ouverture (ou les ouvertures) 5 de la zone de pré-détachage, on peut prévoir deux étapes de masquage. Dans ce cas, une première étape de masquage est réalisée pour graver la ou les ouvertures 5 de la zone de pré-détachage 4. Une deuxième étape de masquage est ensuite réalisée pour graver le composant horloger 1 et ses attaches 3, tout en protégeant la ou les ouvertures 5. On pourrait également envisager l'inverse, c'est-à-dire faire un premier masquage pour graver les ouvertures traversantes permettant de former le composant horloger 1 et ses attaches 3, puis un deuxième masquage pour graver la ou les ouvertures de pré-détachage 5 tout en protégeant les ouvertures traversantes. Le masquage peut consister en un masquage mécanique ou un masquage réalisé par photolithographie d'une résine photosensible.

Dans le cas d'une gravure simultanée du composant horloger 1 et de la ou des ouvertures de pré-détachage 5, la profondeur de la ou des ouverture(s) 5 dépend de différents paramètres relatifs à la gravure du composant horloger, notamment la vitesse d'attaque du dispositif de gravure DRIE et la durée de l'attaque. En outre, la profondeur de la ou des ouverture(s) 5 dépend également de la largeur et de la longueur de cette ou ces ouverture(s) 5. En toute hypothèse, dans ce cas, la durée d'attaque par le dispositif de gravure est la même pour réaliser à la fois les ouvertures destinées à former le composant et la ou des ouverture(s) de pré-détachage 5, de façon simultanée. Il est donc préférable que la largeur des ouvertures de pré-détachage 5 soit inférieure à la largeur des ouvertures traversantes formant le composant horloger, ou, dans le cas où les ouvertures traversantes formant le composant horloger présentent des largeurs différentes les unes des autres, inférieure à la plus petite des largeurs des ouvertures traversantes formant le composant horloger. En particulier, si la largeur des ouvertures traversantes formant le composant est supérieure à 40 µm, et/ou est contenue dans une plage de valeurs comprise entre 40 µm et 100µm, ou est supérieure à 100 µm, la largeur des ouvertures de pré-détachage 5 sera avantageusement entre 1 et 10 µm, voire entre 1 et 5 µm. Ainsi, dans le cas où les ouvertures traversantes destinées à former le composant horloger et la ou les ouverture(s) de pré-détachage sont réalisées simultanément, la largeur choisie pour la ou les ouverture(s) de pré-détachage 5 selon l'invention dépend en définitive de la plus petite des largeurs des ouvertures traversantes formant le composant horloger et de la profondeur souhaitée pour la ou les ouverture(s) de pré-détachage. De plus, la largeur de la ou des ouverture(s) de pré-détachage peut dépendre de particularités du procédé et/ou de l'équipement de gravure DRIE utilisé. L'homme du métier saura effectuer les tests d'ajustement nécessaires pour déterminer la largeur optimale des ouvertures de pré-détachage 5.

Le procédé peut également comprendre des étapes supplémentaires de traitement, réalisées avant ou après libération du composant, telles qu'un amincissement préalable de la plaque de matériau micro-usinable (pour réduire son épaisseur), un dépôt de revêtement, un traitement thermique d'oxydation, un nettoyage/dégraissage, etc.

On va maintenant décrire différentes formes ou variantes de réalisation de la zone de pré-détachage en référence aux figures 10A à 10F. Sur ces figures, la ligne de rupture le long de laquelle s'étend la zone de pré-détachage est notée « L ».

Dans le cas d'une zone de pré-détachage comportant une ouverture continue 5, du type de celle représentée sur les figures 1A et 1B, on pourrait graver une ouverture de pré-détachage 5 de largeur variable le long de la ligne de rupture. Dans ce cas, cela permet de faire varier également la profondeur de l'ouverture le long de la ligne de rupture, notée L, comme représenté sur les figures 10A et 10B, qui représentent respectivement une vue de dessus d'une attache 3 entre la plaque 2 et le composant 1 et une vue zoomée en coupe dans le plan défini par les axes x et z, de l'ouverture de pré-détachage 5.

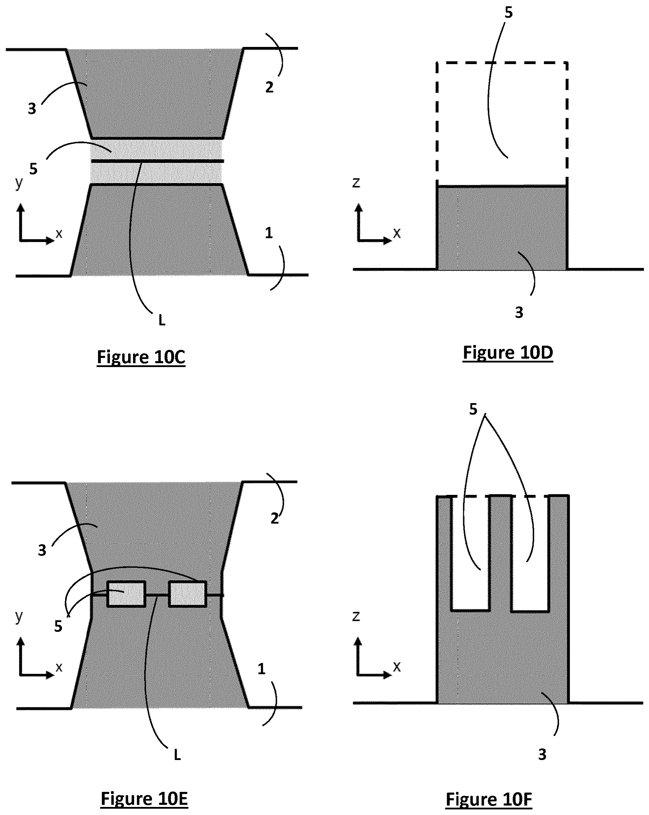

A titre de comparaison les figures 10C et 10D représentent respectivement une vue de dessus d'une attache 3 entre la plaque 2 et le composant 1 et une vue zoomée en coupe dans le plan défini par les axes x et z de l'ouverture de pré-détachage 5, conforme à la première forme de réalisation dans laquelle la largeur et la profondeur de l'ouverture de pré-détachage 5 sont constantes le long de la ligne de rupture L.

Les figures 10E et 10F représentent respectivement une vue de dessus d'une attache 3 entre la plaque 2 et le composant 1 et une vue zoomée en coupe dans le plan défini par les axes x et z, de l'ouverture de pré-détachage 5, conforme à la deuxième forme de réalisation dans laquelle la zone de pré-détachage comporte une pluralité d'ouvertures alignées le long de la ligne de rupture L.

La présence d'une ligne de rupture est avantageuse car elle permet de déterminer précisément la localisation et l'étendue de la surface de rupture. Ceci n'est pas le cas si on utilise une technique connue de l'art antérieur consistant, par exemple, à prévoir un simple pont de matière ou un pont de matière de moindre largeur et/ou de moindre épaisseur. Dans ce cas, l'endroit de la rupture n'est pas précisément déterminé. Il peut se trouver quelque part le long du pont de matière affaibli, et peut aussi bien être proche du composant que du reste de la plaque. Il en résulte une incertitude sur la localisation de la rupture. De plus, dans certains cas, la rupture dégrade l'aspect esthétique du composant, voire même son efficacité de fonctionnement, ce qui s'avère particulièrement gênant.

L'invention concerne aussi un composant horloger présentant une zone de rupture partiellement gravée. Par « zone de rupture », on entend désigner la portion de tranche du composant (sur toute l'épaisseur du composant) contenant une ou plusieurs surfaces de rupture. Selon le mode de réalisation du procédé de fabrication du composant, la zone de rupture peut comprendre :
- une partie entièrement gravée et une partie entièrement rompue disposées l'une au-dessus de l'autre (selon l'épaisseur du composant) ;
- une partie comportant une succession alternée de rainures gravées et de rainures rompues, et une partie entièrement rompue, disposées l'une au-dessus de l'autre (selon l'épaisseur du composant);
- une succession alternée de rainures gravées et de rainures rompues (sur toute l'épaisseur du composant).
attaches 3, puis un deuxième masquage pour graver la ou les ouvertures de pré-détachage 5 tout en protégeant les ouvertures traversantes. Le masquage peut consister en un masquage mécanique ou un masquage réalisé par photolithographie d'une résine photosensible.

Dans le cas d'une gravure simultanée du composant horloger 1 et de la ou des ouvertures de pré-détachage 5, la profondeur de la ou des ouverture(s) 5 dépend de différents paramètres relatifs à la gravure du composant horloger, notamment la vitesse d'attaque du dispositif de gravure DRIE et la durée de l'attaque. En outre, la profondeur de la ou des ouverture(s) 5 dépend également de la largeur et de la longueur de cette ou ces ouverture(s) 5. En toute hypothèse, dans ce cas, la durée d'attaque par le dispositif de gravure est la même pour réaliser à la fois les ouvertures destinées à former le composant et la ou des ouverture(s) de pré-détachage 5, de façon simultanée. Il est donc préférable que la largeur des ouvertures de pré-détachage 5 soit inférieure à la largeur des ouvertures traversantes formant le composant horloger, ou, dans le cas où les ouvertures traversantes formant le composant horloger présentent des largeurs différentes les unes des autres, inférieure à la plus petite des largeurs des ouvertures traversantes formant le composant horloger. En particulier, si la largeur des ouvertures traversantes formant le composant est supérieure à 40 µm, et/ou est contenue dans une plage de valeurs comprise entre 40 µm et 100µm, ou est supérieure à 100 µm, la largeur des ouvertures de pré-détachage 5 sera avantageusement entre 1 et 10 µm, voire entre 1 et 5 µm. Ainsi, dans le cas où les ouvertures traversantes destinées à former le composant horloger et la ou les ouverture(s) de pré-détachage sont réalisées simultanément, la largeur choisie pour la ou les ouverture(s) de pré-détachage 5 selon l'invention dépend en définitive de la plus petite des largeurs des ouvertures traversantes formant le composant horloger et de la profondeur souhaitée pour la ou les ouverture(s) de pré-détachage. De plus, la largeur de la ou des ouverture(s) de pré-détachage peut dépendre de particularités du procédé et/ou de l'équipement de gravure DRIE utilisé. L'homme du métier saura effectuer les tests d'ajustement nécessaires pour déterminer la largeur optimale des ouvertures de pré-détachage 5.

Le procédé peut également comprendre des étapes supplémentaires de traitement, réalisées avant ou après libération du composant, telles qu'un amincissement préalable de la plaque de matériau micro-usinable (pour réduire son épaisseur), un dépôt de revêtement, un traitement thermique d'oxydation, un nettoyage/dégraissage, etc.

On va maintenant décrire différentes formes ou variantes de réalisation de la zone de pré-détachage en référence aux figures 10A à 10F. Sur ces figures, la ligne de rupture le long de laquelle s'étend la zone de pré-détachage est notée « L ».

Dans le cas d'une zone de pré-détachage comportant une ouverture continue 5, du type de celle représentée sur les figures 1A et 1B, on pourrait graver une ouverture de pré-détachage 5 de largeur variable le long de la ligne de rupture. Dans ce cas, cela permet de faire varier également la profondeur de l'ouverture le long de la ligne de rupture, notée L, comme représenté sur les figures 10A et 10B, qui représentent respectivement une vue de dessus d'une attache 3 entre la plaque 2 et le composant 1 et une vue zoomée en coupe dans le plan défini par les axes x et z, de l'ouverture de pré-détachage 5.

A titre de comparaison les figures 10C et 10D représentent respectivement une vue de dessus d'une attache 3 entre la plaque 2 et le composant 1 et une vue zoomée en coupe dans le plan défini par les axes x et z de l'ouverture de pré-détachage 5, conforme à la première forme de réalisation dans laquelle la largeur et la profondeur de l'ouverture de pré-détachage 5 sont constantes le long de la ligne de rupture L.

Les figures 10E et 10F représentent respectivement une vue de dessus d'une attache 3 entre la plaque 2 et le composant 1 et une vue zoomée en coupe dans le plan défini par les axes x et z, de l'ouverture de pré-détachage 5, conforme à la deuxième forme de réalisation dans laquelle la zone de pré-détachage comporte une pluralité d'ouvertures alignées le long de la ligne de rupture L.

La présence d'une ligne de rupture est avantageuse car elle permet de déterminer précisément la localisation et l'étendue de la surface de rupture. Ceci n'est pas le cas si on utilise une technique connue de l'art antérieur consistant, par exemple, à prévoir un simple pont de matière ou un pont de matière de moindre largeur et/ou de moindre épaisseur. Dans ce cas, l'endroit de la rupture n'est pas précisément déterminé. Il peut se trouver quelque part le long du pont de matière affaibli, et peut aussi bien être proche du composant que du reste de la plaque. Il en résulte une incertitude sur la localisation de la rupture. De plus, dans certains cas, la rupture dégrade l'aspect esthétique du composant, voire même son efficacité de fonctionnement, ce qui s'avère particulièrement gênant.

L'invention concerne aussi un composant horloger présentant une zone de rupture partiellement gravée. Par « zone de rupture », on entend désigner la portion de tranche du composant (sur toute l'épaisseur du composant) contenant une ou plusieurs surfaces de rupture. Selon le mode de réalisation du procédé de fabrication du composant, la zone de rupture peut comprendre :
- une partie entièrement gravée et une partie entièrement rompue disposées l'une au-dessus de l'autre (selon l'épaisseur du composant) ;
- une partie comportant une succession alternée de rainures gravées et de rainures rompues, et une partie entièrement rompue, disposées l'une au-dessus de l'autre (selon l'épaisseur du composant);
- une succession alternée de rainures gravées et de rainures rompues (sur toute l'épaisseur du composant).

## Revendications

1. Composant horloger (1) en matériau micro-usinable, comportant une zone (4) de rupture partiellement gravée,
**caractérisé en ce que** ladite zone (4) de rupture comprend une partie comportant une succession alternée de rainures gravées et de rainures rompues, et une partie entièrement rompue, disposées l'une au-dessus de l'autre selon l'épaisseur du composant,
ou **en ce que** ladite zone (4) de rupture comprend une succession alternée de rainures gravées et de rainures rompues sur toute l'épaisseur du composant.

2. Composant horloger (1) en matériau micro-usinable selon la revendication précédente, **caractérisé en ce que** ladite zone (4) de rupture s'étend le long d'une ligne de rupture (L).

3. Composant horloger (1) en matériau micro-usinable selon la revendication précédente, **caractérisé en ce que** ladite zone (4) de rupture s'étend le long de la totalité de la ligne de rupture (L).

4. Composant horloger (1) en matériau micro-usinable selon la revendication 2 ou 3, **caractérisé en ce que** ladite zone (4) de rupture comprend une partie gravée de profondeur inférieure ou égale à 90% de l'épaisseur du composant horloger (1), préférentiellement inférieure ou égale à 60% de ladite épaisseur, et supérieure ou égale à la moitié de l'épaisseur du composant horloger (1).

5. Composant horloger (1) en matériau micro-usinable selon l'une des revendications précédentes, **caractérisé en ce que** le matériau du composant horloger (1) est un matériau fragile, notamment l'un des matériaux du groupe comportant le silicium, le diamant, le quartz et la céramique.

6. Composant horloger (1) en matériau micro-usinable selon l'une des revendications précédentes, **caractérisé en ce qu'**il est l'un des éléments du groupe comportant un spiral, une roue, une aiguille, un ressort, une ancre et un balancier.

7. Composant horloger (1) en matériau micro-usinable selon l'une des revendications précédentes, **caractérisé en ce qu'**il est obtenu à partir d'une plaque en matériau micro-usinable comportant ledit composant horloger (1) et au moins une attache (3) de maintien entre le composant horloger (1) et le reste de la plaque (2), formés par des ouvertures gravées dans l'épaisseur de la plaque (2), et **caractérisé par le fait que** la plaque (2) comprend une zone (4) de pré-détachage du composant horloger (1) comportant, le long d'une ligne (L) de rupture souhaitée de l'attache (3), au moins une ouverture (5) gravée dans l'épaisseur de la plaque (2).

8. Composant horloger (1) en matériau micro-usinable selon la revendication précédente, **caractérisé en ce que** la profondeur de la au moins une ouverture (5) est inférieure ou égale à 90% de l'épaisseur de la plaque (2), préférentiellement inférieure ou égale à 60% de ladite épaisseur, et supérieure ou égale à la moitié de l'épaisseur de la plaque (2).

9. Procédé de fabrication d'un composant horloger (1) en matériau micro-usinable selon l'une des revendications précédentes, comportant les étapes suivantes
• se munir (S1) d'une plaque (2) en un matériau micro-usinable ;
• former (S2) le composant horloger (1) avec au moins une attache (3) de maintien au reste de la plaque (2), par gravure de la plaque (2) ;
• réaliser (S3), le long d'une ligne (L) de rupture souhaitée de l'attache, une zone de pré-détachage (4) comportant au moins une ouverture (5) obtenue par gravure dans l'épaisseur de la plaque (2) ;
• libérer (S4) le composant horloger (1) de la plaque (2), par rupture ou casse de la au moins une attache (3) le long de la ligne de rupture.

10. Procédé de fabrication d'un composant horloger (1) en matériau micro-usinable selon la revendication précédente, **caractérisé en ce que** la profondeur de la au moins une ouverture (5) est inférieure ou égale à 90% de l'épaisseur de la plaque (2), préférentiellement inférieure ou égale à 60% de ladite épaisseur, et supérieure ou égale à la moitié de l'épaisseur de la plaque (2).

11. Procédé de fabrication d'un composant horloger (1) en matériau micro-usinable selon l'une des revendications 9 à 10, **caractérisé en ce que** l'étape consistant à former (S2) le composant horloger (1) avec au moins une attache (3) de maintien au reste de la plaque (2) est réalisée par gravure ionique réactive profonde, et **en ce que** l'étape consistant à réaliser (S3), le long d'une ligne (L) de rupture souhaitée de l'attache, une zone de pré-détachage (4), est réalisée par gravure au moyen d'impulsions laser femtosecondes.

## Patentansprüche

1. Uhrkomponente (1) aus mikrobearbeitbarem Material, welche einen teilweise gravierten Bruchbereich (4) aufweist,
**dadurch gekennzeichnet, dass** der Bruchbereich (4) einen Teil, der eine alternierende Folge von gravierten Nuten und gebrochenen Nuten aufweist, und einen vollständig gebrochenen Teil umfasst, die übereinander entlang der Dicke der Komponente angeordnet sind,
oder dadurch, dass der Bruchbereich (4) eine alternierende Folge von gravierten Nuten und gebrochenen Nuten auf der gesamte Dicke der Komponente umfasst.

2. Uhrkomponente (1) aus mikrobearbeitbarem Material nach dem vorhergehenden Anspruch, **dadurch gekennzeichnet, dass** sich der Bruchbereich (4) entlang einer Bruchlinie (L) erstreckt.

3. Uhrkomponente (1) aus mikrobearbeitbarem Material nach dem vorhergehenden Anspruch, **dadurch gekennzeichnet, dass** sich der Bruchbereich (4) entlang der gesamten Bruchlinie (L) erstreckt.

4. Uhrkomponente (1) aus mikrobearbeitbarem Material nach Anspruch 2 oder 3, **dadurch gekennzeichnet, dass** der Bruchbereich (4) einen gravierten Teil mit einer Tiefe umfasst, die kleiner oder gleich 90 % der Dicke der Uhrkomponente (1), vorzugsweise kleiner oder gleich 60 % dieser Dicke, und größer oder gleich der Hälfte der Dicke der Uhrkomponente (1) ist.

5. Uhrkomponente (1) aus mikrobearbeitbarem Material nach einem der vorhergehenden Ansprüche, **dadurch gekennzeichnet, dass** das Material der Uhrkomponente (1) ein sprödes Material ist, insbesondere eines der Materialien der Gruppe, welche Silizium, Diamant, Quarz und Keramik umfasst.

6. Uhrkomponente (1) aus mikrobearbeitbarem Material nach einem der vorhergehenden Ansprüche, **dadurch gekennzeichnet, dass** sie eines der Elemente der Gruppe ist, welche eine Spirale, ein Rad, einen Zeiger, eine Feder, einen Anker und eine Unruh umfasst.

7. Uhrkomponente (1) aus mikrobearbeitbarem Material nach einem der vorhergehenden Ansprüche, **dadurch gekennzeichnet, dass** sie aus einer Platte aus mikrobearbeitbarem Material erhalten wird, welche die Uhrkomponente (1) und mindestens ein Befestigungselement (3) zum Halten zwischen der Uhrkomponente (1) und dem Rest der Platte (2) aufweist, gebildet durch in die Dicke der Platte (2) eingravierte Öffnungen, und **dadurch gekennzeichnet, dass** die Platte (2) einen Vor-Abtrennungsbereich (4) der Uhrkomponente (1) umfasst, der entlang einer gewünschten Bruchlinie (L) des Befestigungselements (3) mindestens eine in die Dicke der Platte (2) eingravierte Öffnung (5) aufweist.

8. Uhrkomponente (1) aus mikrobearbeitbarem Material nach dem vorhergehenden Anspruch, **dadurch gekennzeichnet, dass** die Tiefe der mindestens einen Öffnung (5) kleiner oder gleich 90 % der Dicke der Platte (2), vorzugsweise kleiner oder gleich 60 % dieser Dicke, und größer oder gleich der Hälfte der Dicke der Platte (2) ist.

9. Verfahren zur Herstellung einer Uhrkomponente (1) aus mikrobearbeitbarem Material nach einem der vorhergehenden Ansprüche, welches die folgenden Schritte umfasst:
• Bereitstellen (S1) einer Platte (2) aus einem mikrobearbeitbarem Material;
• Ausbilden (S2) der Uhrkomponente (1) mit mindestens einem Befestigungselement (3) zum Halten am Rest der Platte (2) durch Gravieren der Platte (2);
• Herstellen (S3), entlang einer gewünschten Bruchlinie (L) des Befestigungselements, eines Vor-Abtrennungsbereichs (4), der mindestens eine durch Eingravieren in die Dicke der Platte (2) erhaltene Öffnung (5) aufweist;
• Trennen (S4) der Uhrkomponente (1) der Platte (2) durch Zerreißen oder Brechen des mindestens einen Befestigungselements (3) entlang der Bruchlinie.

10. Verfahren zur Herstellung einer Uhrkomponente (1) aus mikrobearbeitbarem Material nach dem vorhergehenden Anspruch, **dadurch gekennzeichnet, dass** die Tiefe der mindestens einen Öffnung (5) kleiner oder gleich 90 % der Dicke der Platte (2), vorzugsweise kleiner oder gleich 60 % dieser Dicke, und größer oder gleich der Hälfte der Dicke der Platte (2) ist.

11. Verfahren zur Herstellung einer Uhrkomponente (1) aus mikrobearbeitbarem Material nach einem der Ansprüche 9 bis 10, **dadurch gekennzeichnet, dass** der Schritt, der darin besteht, die Uhrkomponente (1) mit mindestens einem Befestigungselement (3) zum Halten am Rest der Platte (2) auszubilden (S2), durch reaktives Ionentiefenätzen ausgeführt wird, und dadurch, dass der Schritt, der darin besteht, entlang einer gewünschten Bruchlinie (L) des Befestigungselements einen Vor-Abtrennungsbereich (4) herzustellen (S3), durch Ätzen mit Femtosekunden-Laserimpulsen ausgeführt wird.

## Claims

1. A horology component (1) made of a micromachinable material comprising a partially etched fracture zone (4), **characterized in that** said fracture zone (4) comprises a part comprising an alternating succession of etched grooves and fractured grooves, and an entirely fractured part, which are arranged one above the other, or **in that** said fracture zone (4) comprises an alternating succession of etched grooves and of fractured grooves over the entire thickness of the component.

2. A horology component (1) made of a micromachinable material as claimed in the preceding claim, **characterized in that** said fracture zone (4) extends along a fracture line (L).

3. A horology component (1) made of a micromachinable material as claimed in the preceding claim, **characterized in that** said fracture zone (4) extends along the entirety of the fracture line (L).

4. A horology component (1) made of a micromachinable material as claimed in claim 2 or 3, **characterized in that** said fracture zone (4) comprises an etched part whose depth is less than or equal to 90% of the thickness of the horology component (1), preferably less than or equal to 60% of said thickness, and greater than or equal to half the thickness of the horology component (1).

5. A horology component (1) made of a micromachinable material as claimed in one of previous claims, **characterized in that** the material of the horology component (1) is a brittle material, notably one of the materials from the group containing silicon, diamond, quartz and ceramic.

6. A horology component (1) made of a micromachinable material as claimed in one of previous claims, **characterized in that** it is one of the elements from the group comprising a balance spring, a wheel, a hand, a spring, a pallet and a balance-wheel.

7. A horology component (1) made of a micromachinable material as claimed in one of previous claims, **characterized in that** it is made from a sheet of micromachinable material comprising said horology component (1) and at least one attachment (3) tethering the horology component (1) to the rest of the sheet (2), these being formed by openings etched into the thickness of the sheet (2), and **in that** the sheet (2) comprises a zone (4) for predetachment of the horology component (1) comprising, along a line (L) of desired fracture of the attachment (3), at least one opening (5) etched into the thickness of the sheet (2).

8. A horology component (1) made of a micromachinable material as claimed in the preceding claim, **characterized in that** the depth of the at least one opening (5) is less than or equal to 90% of the thickness of the sheet (2), preferably less than or equal to 60% of said thickness, and greater than or equal to half the thickness of the sheet (2).

9. A method for manufacturing a horology component (1) made of a micromachinable material, comprising the following steps:
- procuring (S1) a sheet (2) of a micromachinable material;
- forming (S2) the horology component (1) with at least one attachment (3) tethering it to the rest of the sheet (2), by etching the sheet (2);
- creating (S3), along a line (L) of desired fracture of the attachment, a predetachment zone (4) comprising at least one opening (5) obtained by etching into the thickness of the sheet (2) ;
- freeing (S4) the horology component (1) from the sheet (2), by fracturing the attachment (3) along the fracture line (L).

10. A method for manufacturing a horology component (1) made of a micromachinable material as claimed in the preceding claim, **characterized in that** the depth of the at least one opening (5) is less than or equal to 90% of the thickness of the sheet (2), preferably less than or equal to 60% of said thickness, and greater than or equal to half the thickness of the sheet (2).

11. A method for manufacturing a horology component (1) made of a micromachinable material as claimed in claim 9 or 10, **characterized in that** the step of forming (S2) the horology component (1) with at least one attachment (3) tethering it to the rest of the sheet (2) is performed using deep reactive ion etching, and **in that** the step of creating (S3), along a line (L) of desired fracture of the attachment, a predetachment zone (4), is performed using femtosecond laser micromachining.
